# EUROPEAN PATENT SPECIFICATION

(11) **EP 1 779 692 B1**
(45) Date of publication and mention of the grant of the patent: **22.07.2009**
(21) Application number: 05779852.2
(22) Date of filing: 18.08.2005
(51) Int. Cl.: H04W 88/02, H04L 5/06, H04B 1/04

(54) **Apparatus and method of signal amplification**
Vorrichtung und Verfahren zur Signalverstärkung
Appareil et procédé d'amplification de signaux

(30) Priority: 18.08.2004 GB 0418473
(43) Date of publication of application: 02.05.2007
(73) Proprietor: Thales Holdings UK Plc, Addlestone, Near Weybridge, Surrey KT15 2NX (GB)
(72) Inventor: RUSSEL, David, Philip, FIRCROFT West Sussex RH19 2JN (GB)
(74) Representative: Lucas, Laurent Jacques
(86) International application number: PCT/EP2005/054085
(87) International publication number: WO 2006/018444

(56) References cited:
- EP-A- 0 939 452
- WO-A-03/043127

## Description

The present invention relates to signal amplification apparatus and methods. In particular, though not exclusively, the present invention relates to the amplification of multiple concurrent communications signals to be transmitted wirelessly (e.g. via an antenna).

Wireless transmission of multiple current communication signals often requires the provision of multiple transmitting antennas at the transmission location. While it is possible to transmit multiple wireless signals from a single common antenna, such as via a time-division multiplexing technique or the like, such techniques inherently enforce transmission delay. Providing additional transmitting antennas reduces such delays but increases the physical space occupied by the wireless transmitting apparatus and its environs.

In many wireless transmission platforms little or no space exists in which to locate additional transmitting antennas. Examples include transmitter towers, the roofs or outer walls of buildings, the decks and superstructure of ships or the bodies or outer surfaces of road vehicles or aircraft. Where an increase in communications capacity is desired using such communications platforms, it may be required to do so without installing additional antennas for this reason.

WO03043127 discloses an antenna system for use in transmitting and/or receiving at least two signals, whereby a first one of said signals is generated in a first operator frequency band by a first operator and a second one of said signals is generated in a second operator frequency band by a second operator, the antenna system comprising: an antenna assembly having an adjustable angle of electrical tilt, and including a plurality of antenna elements for transmitting and/or receiving said signals, wherein the antenna elements are mounted upon an antenna carrier and are arranged in at least two sub-arrays, each sub-array including one or more of said elements, control means for controlling electrically the phase of signals transmitted and/or received by said antenna assembly, thereby to control the angle of electrical tilt of said antenna assembly; and combiner means for enabling said antenna assembly to transmit and/or receive substantially simultaneously a first one of said signals at a first angle of electrical tilt and a second one of said signals at a second angle of electrical tilt.

The present invention aims to provide a method and apparatus which may be used in addressing at least some of the aforementioned deficiencies in the prior art.

At its most basic, the present invention proposes a signal amplifier apparatus (e.g. for a wireless transmission system) with multiple signal channels and a multiplicity of pre-transmission signal amplifiers each one of which, when idle, is made available to and adapted for use by any of the signal channels requiring it. In this way, signal channels are not restricted to a single dedicated pre-transmission signal amplifier and may employ any idle one of the multiplicity of amplifiers as and when available. This adaptive sharing of a limited number of amplifiers effectively reduces the time a given signal, upon a signal transmission channel, is required to queue awaiting transmission, and effectively maximises utilisation of all pre-transmission amplifiers.

In a first of its aspects, the present invention may provide a signal amplifier apparatus for use with a wireless communications signal transmitter, the apparatus including a plurality of signal amplifier means each arranged to amplify communications signals received thereby for wireless transmission, allocating means operable to receive a plurality of (e.g.concurrent) communications signals and to allocate to each such signal a respective signal amplifier means not engaged (e.g. currently or actively engaged) in signal amplification, and tuning means operable to vary characteristics (e.g. the frequency response) of an allocated amplifier means according to the characteristics (e.g. the frequency) of a given communications signal to which it is allocated so as to render the allocated amplifier operable to amplify the given communications signal.

Thus, the signal amplifier apparatus selects from the plurality of amplifier means an idle amplifier, and adjusts the characteristics thereof in order to enable it to be successfully used by the communications channel to which it has been allocated.

Preferably, the tuning means is operable to vary characteristics (e.g. the frequency response) of an allocated amplifier means in response to the allocation thereof to a received communications signal. Thus, the tuning of an allocated amplifier may occur before any of the communications signal to which it has been allocated is received thereby, such tuning being prompted by allocation alone. Alternatively, tuning may occur upon receipt of a new signal at a newly allocated amplifier means. The tuning means may be arranged in association with, or be a part of, a given amplifier means, or may be arranged separately of, but in association with, a given amplifier means being operable to control the characteristics of the amplifier, to detect the allocation of an amplifier to a given communication signal, and to determine the characteristics (e.g. frequency) of the communication signal in question.

The amplifier may contain a harmonic filter means having a variable frequency characteristic. The tuning means may then be arranged to vary the frequency characteristics of the harmonic filter means e.g. by simple selection of a suitable harmonic filter, or filters, from a plurality of such filters within the harmonic filter means.

The allocating means preferably has a plurality of signal input ports for receiving said communications signals, and preferably a plurality of signal output ports arranged to output received communications signals to the plurality of signal amplifier means for amplification. Preferably switching means are provided intermediate the plurality of signal input and output ports, being operable to selectively interconnect signal input ports to selected signal output ports thereby to route received communications signals to the signal amplifiers allocated thereto.

Most preferably, the allocating means possesses a greater number of signal input ports than signal output ports. Consequently, the apparatus may be used to serve more signal channels than there are amplifier means. The ability of the apparatus to use any idle amplifier greatly reduces the likelihood that a given channel will be unavailable to a user upon request since it is unlikely that all channels will be in constant operation/use.

Preferably, the switching means is operable to interconnect a given signal input port of the allocating means to a single selected signal output port thereof. Alternatively, if desired, a given input port may connect a signal received thereon to multiple output ports simultaneously.

Each one of said plurality of amplifier means is preferably arranged to receive and amplify communications signals from a respective separate one of the signal output ports of the allocating means. A signal output port of the allocating means may be arranged to output signals to a single amplifier means dedicated to that output port alone, or may output to multiple amplifiers.

Preferably, the allocating means includes monitoring means operable to determine which of the plurality of amplifier means are not engaged in signal amplification. Thus, the allocating means preferably determines/detects an idle amplifier means and determines the output port(s) of the allocating means to which it is operably connected. Allocation to a given communications signal may then involve the switching means interconnecting the output port so determined to the input port associated with the given signal.

The allocating means preferably contains control circuitry (and/or control software) which performs the monitoring function, and which stores information concerning which amplifier(s) it has allocated to which communications signal. Preferably, the amplifiers are arranged to generate status signals and to communicate them to the monitoring means. The status signals are arranged e.g. to indicate if an amplifier associated with a given status signal is available to be allocated, e.g. whether or not it is switched off or faulty, or whether or not it is currently idle/unallocated or active/allocated.

The allocating means preferably monitors its input ports for the presence/absence of communications signals thereat in order to determine when to allocate an amplifier. For example, an amplifier preferably becomes idle when the communications line to which it has been allocated (e.g. a "press-to-talk" (PTT) line) is released from use, however briefly. The allocating means may monitor the output lines of all of the signal generators/exciters connected to it and which are used to generate the communications signals input to the allocating means.

One or more (e.g. each) of the amplifier means may include signal filter means for variably filtering said communications signals received thereby. The tuner means is preferably operable to vary the frequency response of an allocated amplifier means by varying the signal filtering provided by the filter means thereof. The filtering means may include multiple harmonic filters and the varying of the signal filtering may be the selection of appropriate harmonic filters for filtering a given signal.

The apparatus may include a plurality of communications signal generators wherein each one of the plurality of communication signal input ports of the allocating means is arranged to receive communications signals from a respective one of the plurality of communications signal generators.

Preferably, each of the communications signal generators is arranged to generate an activation signal upon activation thereof. Preferably, the allocating means is responsive to a given activation signal to allocate to the given activated signal generator associated therewith an amplifier means not engaged in signal amplification. Activation of a signal generator may correspond with the generation thereby of a communications signal for immediate transmission or simply switching on (or placing in a state of readiness) of the signal generator for subsequent communications signals. The activation signal may be a signal generated by a signal generator when a user operates the signal generator to open/use a communications channel in use.

The tuning means may be operable to tune the frequency response of an allocated amplifier means substantially to overlap the signal frequency bandwidth of the communications signal to which it is allocated. Preferably the allocated amplifier means is tuned to be responsive to all frequencies falling within the signal frequency bandwidth.

The apparatus may further include signal combiner means arranged to combine amplified communications signals output by said plurality of amplifier means and to output the combined signals for wireless transmission. In this way, multiple communications signals may, after amplification, be wirelessly transmitted via a single common antenna, rather than by multiple separate antennas. This arrangement greatly reduces the space required of a transmission system employing the apparatus.

The apparatus may include splitter means arranged to split a received communications signal into multiple concurrent signal portions and to input each of the multiple signal portions concurrently to a respective one of a corresponding multiplicity of the signal amplifier means. Preferably, the apparatus includes re-combiner means arranged to receive the multiple concurrent signal portions output from the multiplicity of signal amplifier means and to recombine them into a single signal.

In this way, a given signal may be amplified by a multiplicity of amplifiers concurrently/simultaneously thereby to provide a final amplified signal of magnitude greater than that possible by a single one of the multiplicity of amplifiers alone. This permits great versatility in the degree of amplification available via the apparatus.

In order to maximise the gain achieved by such parallel amplification of a split signal, it is preferable that amplified signal portions are recombined in such a way as to avoid destructive interference as between recombined signal portions. This is preferably achieved by recombining amplified signal portions substantially coherently, as opposed to incoherently. That is to say, the re-combiner means is preferable arranged to recombine amplified signal portions, for example, substantially in phase.

Preferably, the splitter means is arranged to split some or all communications signals received thereby into multiple concurrent and substantially coherent signal portions. Preferably, the re-combiner means is arranged to substantially coherently recombine some or all of the concurrent multiple signal portions received thereby.
In order to allow the apparatus additional versatility, the splitter means and the allocating means may be arranged in association with each other to permit the allocating means to selectively allocate the splitter input port to any of the incoming communication signals received by the allocating means. In this way, the apparatus may enable a user to select which of the available signal channels should be subject to the aforementioned parallel multiple signal amplification.

The splitter means may have a splitter input port arranged to receive communications signals from a signal output port of the allocating means. The splitter means may have multiple splitter output ports arranged to output the signal portions to corresponding multiple signal input ports of the allocating means.

The splitter means is preferably arranged to split received signal into substantially identical concurrent signal portions. Transformers may be used to split/combine signals in phase.

In a second of its aspects, the present invention may provide a wireless communications signal transmitter including the signal amplifier apparatus according to the invention in its first aspect including none, some or all of the preferable or alternative variants described above. The signal transmitter may include a transmission antenna means for wirelessly transmitting communications signals output from the signal amplifier apparatus for wireless transmission.

The antenna means may be a single antenna operable to transmit combined signals output by the signal combiner means described above. For example, signal frequencies in the range 1MHz to 100MHz may be employed. The single antenna may be arranged to transmit a broadband signal, comprising a plurality of separated channel frequencies, within a broadband of e.g. 2-30MHz.

The wireless signal transmitter includes the signal amplifier apparatus according to the invention in its first aspect wherein said antenna means includes a plurality of separate antenna elements each operable to separately transmit a different one of the plurality of amplified communications signals output by a respective one of said plurality of amplifier means. A wireless signal transmitter according to this example may be arranged for transmitting Ultra-High Frequency (UHF) wireless communications signals (e.g. MHz frequencies) in which each one of the plurality of separate antenna elements is substantially omni-directional in at least the azimuthal signal transmission plane thereof.

It is to be understood that the invention according to the above aspects defines apparatus implementing a method of signal amplification and/or of wireless signal transmission representing further aspects of this invention such, for example, as set out below.

In a third of its aspects, the present invention may provide a method of signal amplification for use in wireless communications signal transmission, the method including providing a plurality of signal amplifier means each arranged to amplify communications signals received thereby for wireless transmission, providing a plurality of concurrent communications signals and allocating to each such signal a respective signal amplifier means not engaged in signal amplification, and varying characteristics (e.g. the frequency response) of an allocated amplifier means according to characteristics (e.g. the frequency) of a given communications signal to which it is allocated so as to render the allocated amplifier operable to amplify the given communications signal.

The varying of characteristics (e.g. the frequency response) of an allocated amplifier means is preferably done in response to the allocation thereof to a received communications signal.

The method may include providing allocating means for performing the allocating and having a plurality of signal input ports for receiving the communications signals, a plurality of signal output ports arranged to output received communications signals to the plurality of signal amplifier means for amplification. The method preferably includes selectively interconnecting signal input ports to selected signal output ports thereby to route received communications signals to the signal amplifiers allocated thereto.

The method may include providing the allocating means with a greater number of signal input ports than signal output ports.

A given signal input port of the allocating means may be interconnected to a single selected signal output port thereof according to the method.

The method may include receiving and amplifying at each one of the plurality of amplifier means communications signals from a respective separate one of the signal output ports of the allocating means.

Preferably, the method includes monitoring the plurality of amplifier means to determine which thereof are not engaged in signal amplification.

The varying of the frequency response of an allocated amplifier means according to the method may include variably filtering the signal received thereby.

The method may include providing a plurality of communications signal generators and inputting to each one of the plurality of communication signal input ports of the allocating means a communications signal from a respective one of the plurality of communications signal generators.

Preferably, the method includes generating an activation signal upon activation of a communications signal generator, and preferably includes allocating to the given activated signal generator associated therewith an amplifier means not engaged in signal amplification.

The method may include varying the frequency response of an allocated amplifier means substantially to overlap the signal frequency bandwidth of the communications signal to which it is allocated.

The method may include combining amplified communications signals output by the plurality of amplifier means and outputting the combined signals for wireless transmission.

Received communications signal(s) may be split into multiple concurrent signal portions and each may be input concurrently to a respective one of a corresponding multiple of the signal amplifier means. The method preferably includes recombining the multiple concurrent signal portions output from the multiple signal amplifier means into a single signal.

The said splitting of received communications signals is preferably a splitting into multiple concurrent and substantially coherent signal portions.

The aforesaid recombining substantially coherently recombines the concurrent multiple signal portions.

The received signal(s) is preferably split into substantially identical concurrent signal portions.

In a fourth of its aspects, the present invention may provide a method of wireless communications including the method of signal amplification according to the invention in its third aspect and including wirelessly transmitting communications signals output from the signal amplifier apparatus for wireless transmission.

This method of wireless communications signal transmission may include transmitting the aforesaid combined signals from a single antenna.

The method of wireless signal transmission may include separately transmitting each of the plurality of amplified communications signals output by a respective one of said plurality of amplifier means from a different one of a plurality of separate antenna elements.
The method may be for transmitting Ultra-High Frequency (UHF) wireless communications signals and may include transmitting each of said plurality of amplified communications signals substantially omni-directionally in at least the azimuthal signal transmission plane thereof.

There now follow examples of the invention described with reference to the accompanying drawings in which:
Fig. 1 schematically illustrates a wireless communications signal transmitter employing a single transmission antenna;
Fig. 2 illustrates schematically a wireless communications signal transmitter suitable for Ultra-High Frequency (UHF) signal transmission employing multiple discrete and azimuthally substantially omni-directional UHF antennas;
Fig, 3 schematically illustrates the communications signal transmission system of Fig. 1 in more detail;
Fig. 4 schematically illustrates a variant of the system illustrated in Fig. 3;
Fig. 5 schematically illustrates a means for allocating amplifiers to communications signals and for coherent parallel amplification of communications signals;
Fig. 6 graphically illustrates the relationship between the availability of one of a plurality of communications lines upon request by a user of apparatus such as illustrated in Figs. 1 to 4, as a function of the number of communications lines employed in the apparatus;
Fig. 7 graphically illustrates the probability of availability of a given signal communications line in a device as illustrated in Figs. 1 to 4, upon request by a user, as a function of the number of concurrent users thereof.

In the following examples and embodiments, like articles have been assigned like reference symbols.

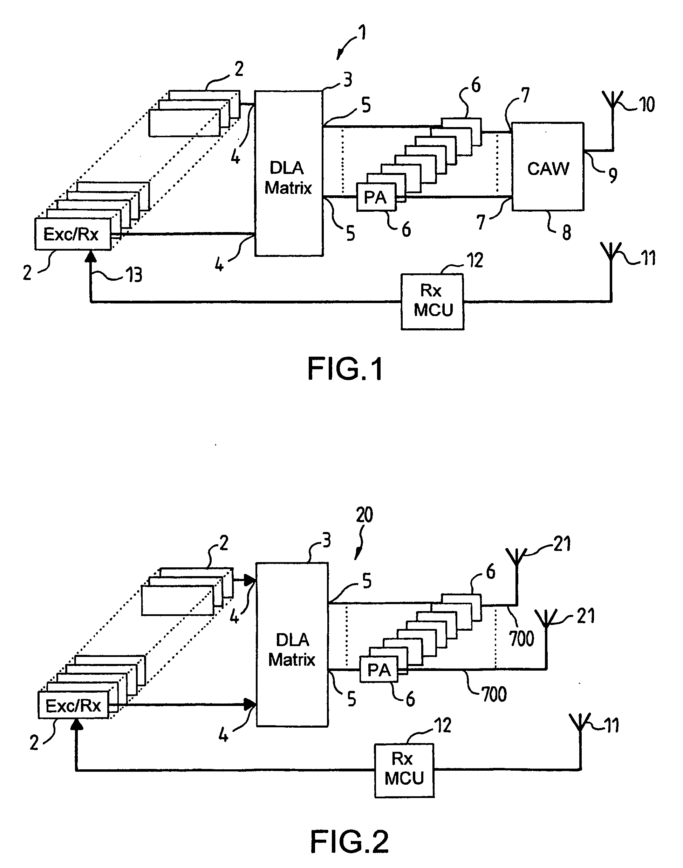

Fig. 1 schematically illustrates a multi-channel communications signal transmitter system 1 according to an embodiment of the present invention.

The transmitter system includes a plurality of exciter units 2 each arranged to generate a communications signal by modulating a carrier signal according to any information to be conveyed using suitable modulation methodology. Each exciter unit 2 may employ a carrier signal of a frequency within a bandwidth of frequencies unique to that exciter within the plurality of exciters. This unique bandwidth defines a corresponding communications channel with which the given exciter is associated. Communications signals generated by an exciter are output thereby, in use, for subsequent amplification and wireless transmission. Each exciter unit may generate communications signals independently of any of the other exciter units such that communications signals concurrently generated by exciters within the multiplicity may be wholly unrelated, each depending solely upon the requirements of the user of the communications channel associated with it.

An array of eight signal power amplifier units 6 is provided within the transmitter system, each being arranged to amplify communications signals within a communications channel, as generated by an exciter unit, prior to wireless transmission thereof. The transmitter includes a combiner unit 8 possessing eight signal input ports 7, each one of which is arranged to receive amplified communications signals generated by a respective one of the eight amplifier units. The combiner unit is arranged to combine amplified communications signals received concurrently at its eight input ports 7, and to output the combined communications signals from a signal output port 9 thereof to a single common antenna 10 for wireless transmission thereof. This arrangement defines a Common Antenna Working (CAW) communications transmitter system.

Intermediate the plurality of exciter units 2, and the array of power amplifier units 6, is a dynamic line allocating (DLA) switch matrix 3. The DLA matrix possesses a plurality of signal input ports 4 each of which is arranged to receive communications signals generated by a respective one of the plurality of exciter units 2, and a multiplicity of signal output ports 5 each of which is arranged to output to a respective one of the array of power amplifier units 6 communications signals received by the DLA matrix.

The number of exciter units 2 exceeds the number (eight) of power amplifier units 6. Thus, the number of input ports 4 of the DLA matrix operably connected to an exciter unit 2 correspondingly exceeds the number of DLA output ports 5 operably connected to a power amplifier unit. The DLA matrix contains switching means arranged to interconnect any one of its signal input ports 4 to any one of its signal output ports 5 thereby to interconnect any exciter unit 2 (communications channel) to any selected power amplifier unit 6. Thus, a power amplification "line", as between the DLA matrix and the CAW combiner unit 8, may be selectively and dynamically allocated to a chosen communications channel as and when required.

To this end, the DLA matrix possesses monitoring means operable to detect whenever any of the eight power amplifiers becomes idle (i.e. not actively engaged in signal amplification). Whenever a user of a communications channel (i.e. a particular exciter unit 2) of the transceiver 1 requires the use of a power amplification line, the DLA matrix is operable to allocate any idle amplifier unit 6 to that channel for use thereby. In order that allocation of an idle amplification line results in effective power amplification of the communications signal within the relevant communications channel, each power amplification line includes a tuner means arranged to vary the frequency response of the associated power amplifier 6 upon allocation thereof to a given communications channel so as to render the power amplifier line operable to amplify signals within the signal frequency bandwidth of the communications channel to which it has been allocated.

The tuning of the power amplifier comprises a single command from the allocating means to the power amplifier to operate at a certain frequency. In response to this command, the power amplifier selects an appropriate harmonic filter, from a plurality of such filters arranged within it, and adjusts its gain ready for the new signal to which it has been allocated. Since the power amplifier typically has a frequency response, i.e. its gain (amplification) varies with frequency, means that this is preferably taken into account when "tuning".

Power amplifiers employed in embodiments of this invention can typically provide the correct gain by two methods: closed loop; or, pre-set. In the closed loop method, the amplifier continuously monitors its signal output and adjusts its gain to maintain a constant output (amplification) level. In the pre-set method, the gain of the amplifier is pre-determined for each frequency it is to operate with, and the amplifier then operates in an "open loop" fashion; the gain parameters are stored in non-volatile memory within the amplifier according to this method.

In configuring the communications system, the DLA unit receives (and stores in a database therein) data concerning the frequency of operation of each exciter. When a new channel (frequency) is selected for use by a given exciter the database must be updated. The optimum method of achieving this will depend on the architecture and management of the communications system and will therefore vary.

With the knowledge of the selected frequency for each exciter, the DLA unit can send the appropriate frequency command to an allocated amplifier at the instant the communications line (e.g. PTT line) to which the amplifier is allocated, is activated/used on an exciter.

The choice of available amplifier is not critical, but typically the DLA unit will go round the pool in a rotational fashion to ensure equal usage of each amplifier.

In this way, a user of a given communications channel (i.e. a given signal frequency bandwidth) may employ any idle amplifier unit 6 when one becomes available, without the need to vary the frequency of the communications signals in question. Rather, a user may employ a single channel having a fixed frequency throughout their use of the present invention since it employs a pool of amplifiers each of which adjusts to the characteristics of the channel requiring it at any given time.

The signal output port 9 of the combiner unit 8 is operably connected to a broadband antenna 10 arranged to transmit the combined, separated (in frequency) communications signal associated with the multiple communications channels (i.e. multiple exciter units 2) of the transmitter over a bandwidth of 2-30MHz. A receiver antenna 11 is also provided in association with a signal receiver unit 12 for receiving incoming wireless communications signals and for conveying those received signals to each of the plurality of exciter units 12 via a communications line such as line 13 illustrated in Fig. 1. Thus, each of the plurality of users of the transmitter system 1 controls an exciter unit 2 via which incoming signals may be received and via which communications signals may be processed for subsequent outgoing wireless transmission. Only two broadband antennas are required for this purpose: a broadband transmitting antenna 10 and a receiving antenna 11 which may or may not also be broadband. The arrangement illustrated in Fig. 1 is particularly suited to high frequency signal transmission of e.g. a mixed form of modulation, and accordingly each of the signal power amplifier units 6 is preferably a high-frequency linear signal power amplifier. Suitable amplifiers, such as would be readily apparent to the skilled person, of any appropriate type may be used.

Fig. 2 schematically illustrates a transmitter system 20 similar in all respects to the transmitter system 1 of Fig. 1 with the exception of the following. The multi-channel communications signal transmitter system 20 is adapted for ultra-high frequency (UHF) signals and, accordingly, each of the signal power amplifiers 6 thereof is a UHF signal power amplifier. Additionally, the power output port 700 of each UHF power amplifier is operably connected to a separate discrete antenna 21 of an array of eight typically UHF antennas 21. Thus, each UHF power amplifiers 6 feeds its own single UHF antenna 21. Each of the UHF antennas is arranged to transmit UHF (e.g. MHz range) wireless communications signals substantially omni-directionally as in the azimuthal transmission plane of the antenna in question. This requirement of omni-directionality ensures that the ability of any given communications channel (i.e. communications signal generated by a given exciter unit 2) to wirelessly communicate in a given direction relative to the transceiver system 20 does not depend upon the power amplifier units and dedicated UHF antenna used by that communications channel. Since power amplifiers are dynamically allocated as and when they are available it is highly likely that, during a sequence of related communications transmissions via a given communications channel, a user will employ not one but several of the eight typically discrete UHF antennas. Were any of these discrete UHF antennas highly directional, or even slightly directional, then wireless communications might be interrupted during use of the directional antenna were that antenna not appropriately aligned/directed.

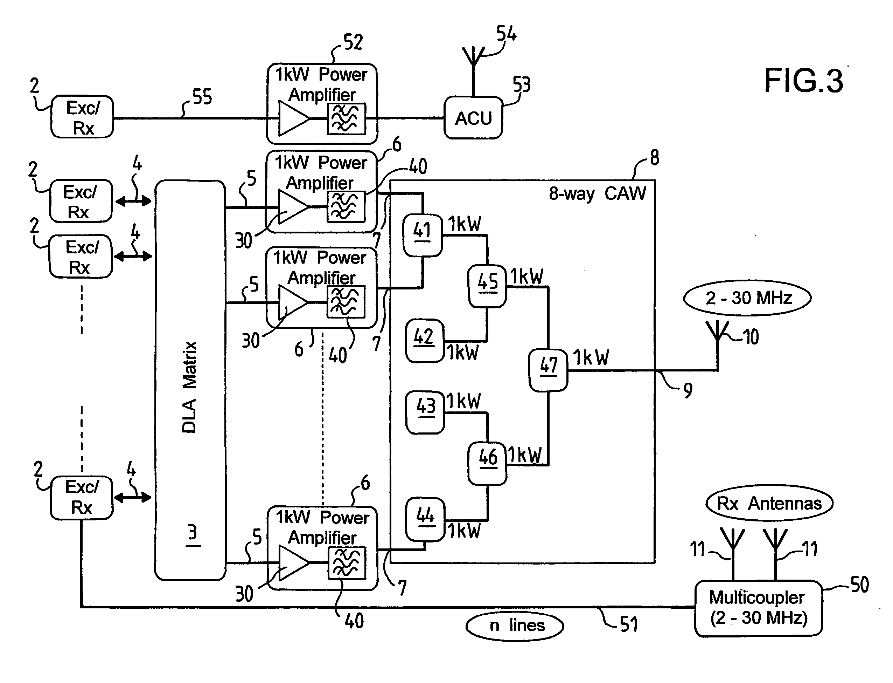

Fig. 3 schematically illustrates a detailed example of the type of CAW transmitter system illustrated in Fig. 1.

Each of the eight amplifier units 6 of the transceiver of Fig. 3 is a 1kW high-frequency signal power amplifier containing signal amplification circuitry 30 of any suitable variety such as will be readily apparent to the skilled person. Communications signals received by an amplifier unit from a communications channel (i.e. an exciter unit 2), to which the amplifier unit is currently assigned, are amplified by the amplification circuitry and subsequently filtered by selected filters of a signal filtering unit 40 arranged within the amplifier unit. The aforementioned tuner means (not shown) is operable to control the filtering unit 40 to vary the filtering provided thereby so as to permit signal frequencies within the bandwidth of the communications channel in question to pass through the filter unit.

A filter unit 40 in this, and any, embodiment may provide a signal band-pass such that signals of a frequency within that band-pass are transmitted by the filter unit, and those of a frequency outwith are not. The tuner means may be arranged to vary the positions, in frequency, of the lower and upper boundaries of the pass-band either separately to vary the pass-band width, or in unison to vary its position but not its width.

The filters preferably serve two purposes: reduction of harmonics; and, reduction of intermodulation products due to the co-siting of transmitters. The harmonics are generated by an amplifier and are most preferably filtered in order to reduce interference, i.e. the filter is most preferably on the signal output of the amplifier. The type of filter is not critical, but would typically be of the low-pass "elliptical" design, which provides a sharper cut-off of unwanted frequencies.

Intermodulation Products (IPs) can be generated by the signal from one amplifier coupling round to the output of another, mainly due to reflection from the antenna (due to its imperfect impedance match (VSWR)). The IPs are created because the output stage of the amplifier generally is not perfectly linear which means that the signals mix to provide unwanted frequencies. The harmonic filter reduces the level of some of these IPs, but the addition of a high-pass filter, in series with the low-pass (harmonic) filter to produce a band-pass filter, significantly reduces the level of the remaining IPs. As this effect occurs at the output stage of the amplifier, these filters are most preferably placed after the amplifier output.

The filter function is in addition to the amplification function and therefore shown separately in the figures, however, in implementation, the filter of a given amplifier unit is most preferably part of the amplifier unit.

It is possible to design an amplifier with a flat frequency response to avoid any need for gain adjustment for use in embodiments of this invention, but harmonic/co-site filtering would still be most preferably employed. As the HF band (1.5 to 30 MHz) covers many octaves, it is most preferable to use a number of harmonic filters. For example, a wanted signal at 1.5 MHz would generate unwanted harmonics at 3, 4.5, 6 MHz, etc, which means that the harmonic filter should preferably block all frequencies from 3 MHz upwards. This filter could be typically used for frequencies up to 2.1 MHz, but beyond that it may start to attenuate the signal and so a second filter would preferably be selected, operating from about 2.1 to 3.2 MHz, with a stop-band starting from about 4.2 MHz. Depending on the sharpness of the filter and the amount of stop-band attenuation required, typically between 6 and 10 filters may be required to cover the HF band.

The tuning means may comprise a tuner circuit or apparatus contained within each amplifier unit 6 and arranged to monitor the frequency of communications signals received by the amplifier unit from the DLA matrix, or arranged to receive channel identifying signals generated from an exciter unit 2 to which a given amplifier unit 6 is operably connected. The tuner unit is, in such cases, responsive to such frequency monitoring, or channel identifier signal reception, to vary the frequency response of the amplifier unit to render it operable to amplify communications signals received thereby from that channel.

Where channel identifiers are employed to notify an amplifier unit of the identity of the channel it has been allocated to, the tuner unit preferably is arranged to associate/identify a corresponding signal frequency bandwidth with the identified channel and to vary the frequency response of the amplifier unit according to the frequency bandwidth so identified.

The combiner unit comprises an array of seven hybrid combiners (41-47) arranged in a sequence of three interconnected banks of successively fewer combiners arrayed to sequentially combine concurrent communications signals received at the eight input ports 7 of the combiner unit 8 from the eight amplifier units 6 intermediate it and the DLA matrix 3.

Each hybrid combiner in the combiner unit 8 comprises two signal input ports for receiving communications signals means for splitting each received communications signals into equal signal portions, each portion being of one half the signal power of the original signal, and means for combining one signal portion of one of the two input signals with one signal portion of the other two input signals 4 for output from the hybrid combiner. In a first bank of four hybrid combiners (41-44) each signal input port of each hybrid of the bank is arranged to receive amplified communications signals from a single respective one of the eight amplifier units 6. Thus, each hybrid of the first bank of four hybrids receives the communications signals from a distinct pair of signal amplification lines of the apparatus, corresponding to two different communications channels. Each such hybrid then combines one half of the signal received from one communications channel with one half of the signal received from the other communications channel, then combines the two halves and outputs the result to a subsequent second bank of two hybrid containers (45 and 46).

Each hybrid of the second bank receives communications signals from a distinct pair of hybrids of the first bank, combines one half of one of such received signals with one half of the other of the received signals in a similar fashion to the above, and outputs the result to a third and final bank of one hybrid combiner 47.

The final hybrid combiner 47 receives the communications signals output by the two hybrids of the second bank, combines one half of one such signal with one half of the other, again in similar fashion to the above, and outputs the result to the signal output port 9 of the combiner unit 8 for wireless transmission.

In this way, the final combined communications signal output from the combiner unit 8 comprises a broadband communications signal including up to eight separate (and separated) narrow-band communications signals in this configuration, each of which corresponds with a respective one of the plurality of communications channels associated with the plurality of exciter units 2. In order to accommodate many separate and separated communications channels the broadband transmission antenna 10 is operable to transmit uniformly over a bandwidth of 2-30MHz.

It is to be noted that since the signals combined by the combiner unit 8 are separated in frequency and are, generally speaking, in no way related to each other, the combined signal portions cannot and do not combine coherently. Thus, a given communications signal associated with a particular communications channel is, upon output from the signal combiner unit 8, at one eighth of its original 1kW signal power at input to the combiner unit (i.e. ½ x ½ x ½; over the three hybrid banks). The total power of the combined signal output from the combiner unit is still approximately 1kW, but this is spread over eight separate channels each of approximately ⅛kW (i.e. 125W) of the transmission power.

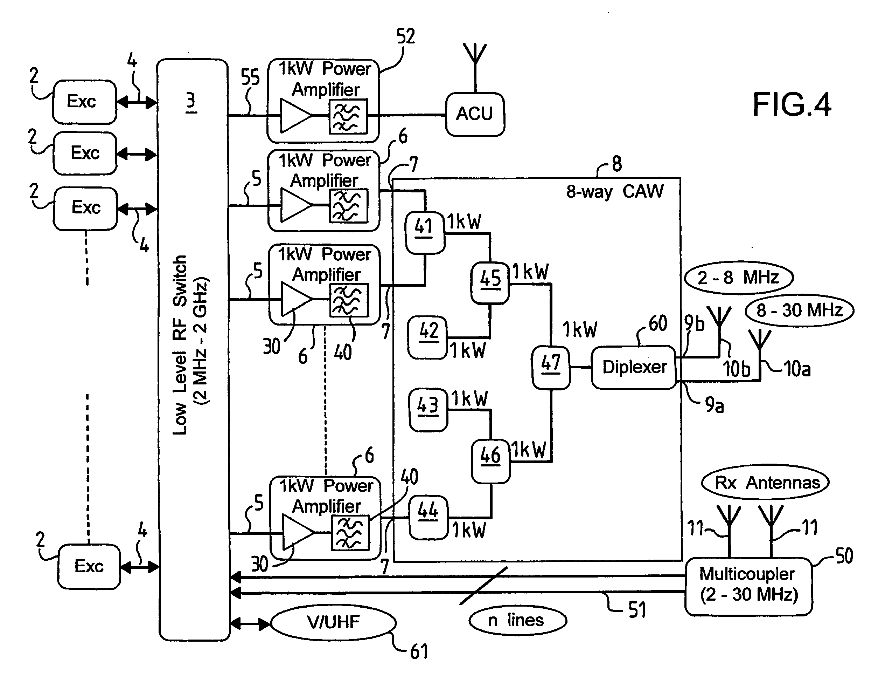

Fig. 4 illustrates schematically a possible modification of the apparatus of any preceding figure permitting a higher degree of signal amplification.

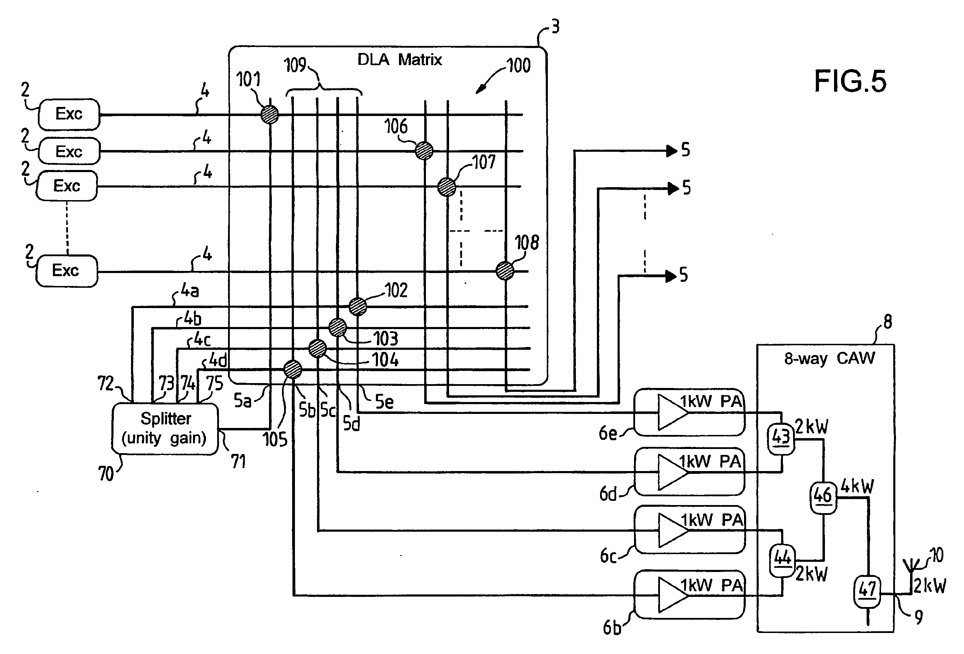

The DLA matrix 3 comprises a switching apparatus 100 illustrated schematically in Figure 5 as an array of signal input lines (4; 4a-4e) each of which is crossed by an array of signal output lines (5; 5a-5e). The switching apparatus is operable to interconnect any one selected input line to any one selected output line by forming a reversible/temporary interconnection (e.g. 101-108) therebetween thereby interconnecting selected communications channel (i.e. signal generator 2) to a selected amplifier unit (6; 6b-6e).

A splitter unit 70 of unity signal gain is provided with a signal input port connected to a signal output port 5a of the DLA matrix, and with four signal output ports (72-75) each connected to a respective one of four signal input ports (4a-4d) of the DLA matrix. The splitter provides unity gain since each of a selected four amplifier units 6b-6e is unaware that it is one of several amplifiers being driven in a phase-coherent manner and simply requires the signal level to be the same as it would normally expect. This arrangement is most preferable when use of open loop (pre-set gain) amplifiers is made. If the amplifiers were to be of the closed loop type mentioned above, then the splitter could have loss and the reduced signal level provided to the amplifiers would be compensated for by each of the selected four amplifiers increasing its gain.

The signal splitter so arranged is operable to receive a communications signal, from a signal channel to which it is interconnected (101) by the DLA matrix, to split the received signal into four identical coherent components, and to output the four signal components concurrently to separate respective inputs of the DLA matrix for subsequent routing thereby. The DLA matrix provides an interconnection (102-105) between each of the input lines associated with the four signal components to be received thereby from the signals splitter unit 70, and a respective one of four signal output lines associated with signal output ports (5b-5e) of the DLA matrix to which a selected four amplifier units (6b-6e) of the combiner unit 8 are connected.

The DLA matrix forms interconnections (106-108) between remaining input and output lines thereof so as to allocate amplifier units 6, other than the selected four amplifier units, to communications channels other than the ones to which the splitter unit 70, and the selected four amplifier units (6b-6e), are allocated.

These other amplifier units may be arranged to output amplified signals to the remaining four input ports of the eight-port combiner unit 8, or may direct their outputs to an additional and separate combiner unit (not shown). The DLA matrix is operable to select the aforesaid selected four amplifier units (6b-6e) to be amplifier units which are arranged in relation to the combiner unit 8 such that the combiner unit will receive all four of the signal components concurrently input to it before combining the recombined signal with any other signals input to it concurrently with the signal components. This recombination is done coherently such that the wave form of each signal component coherently, and substantially constructively, recombine.

The splitter unit 70 may be allocated to any other of the plurality of exciter units 2 simply by removing the interconnection 101 and reforming it again at another communications input line 4 associated with the other exciter unit to which the splitter unit has been reallocated. The previous exciter unit no longer connected to the splitter unit may then have allocated to it any of the other amplifier units 6 not associated with the splitter unit and the DLA matrix may create an interconnection between the communications input line 4 of the previous exciter unit and any communications output line other than those (lines 109) associated with amplifier units (6b-6e) dedicated to the splitter unit.

The combiner unit 8 receives the four amplified signal components concurrently at the four of its input ports associated with a neighbouring two hybrid units 43 and 44 of the first bank of hybrid units which each provide their outputs to a common single hybrid unit 46 of the second bank.

Each of the four signal components is amplified by a respective one of the four selected amplifier units (6b-6e) to a peak power level of 1kW. Each of the two hybrid units of the first bank receives two such 1kW signal components, combines them coherently and outputs the result as a single 2kW signal. The signal hybrid unit of the second bank connected to these two first-bank hybrid units coherently combines the two concurrent 2kW signals therefrom to produce a 4kW recombined communications signal which is, subsequently, combined with other communications signals (other channels) at the ultimate third-bank hybrid unit 47 of the combiner unit for wireless transmission.

The signal combination formed at the ultimate hybrid unit 47 is not coherent and thus the recombined signal reaches the antenna 10 at a peak power level of about 2kW, with additional signal power reaching the antenna from the other communications channels added to the recombined signal at the ultimate hybrid units.

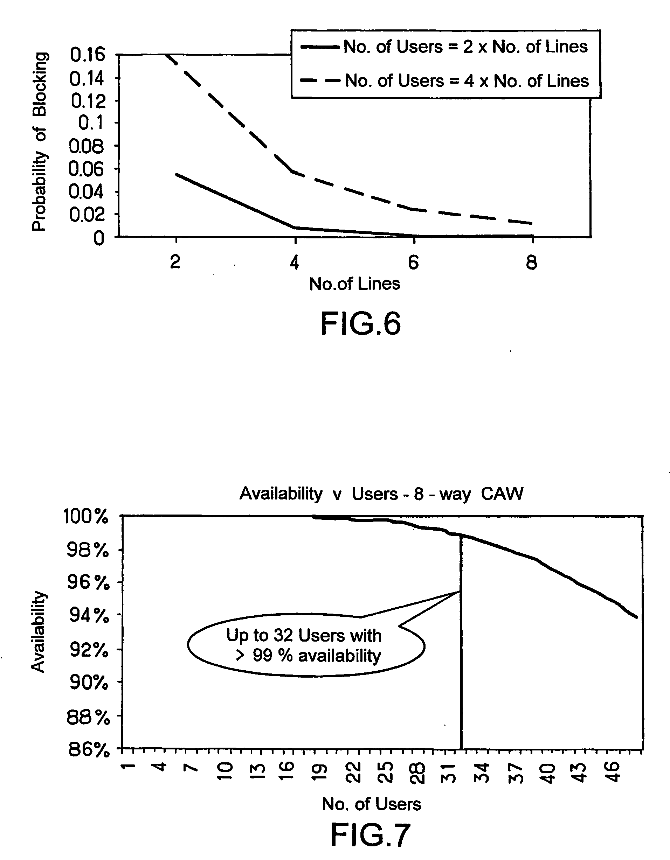

Figure 6 graphically illustrates a measure of the performance of the apparatus according to the present invention in any of its aspects in terms of the probability of "blocking", this being the probability that a user at a given signal exciter unit 2 upon seeking the use of an idle amplifier unit (6a "line") being presented with an "engaged tone" indicating that no such "line" was available at the time of request. Typical results are illustrated, the upper curve corresponds to apparatus in which the number of users (i.e. the number of active signal exciters) is equal to four times the number of lines (i.e. amplifier units). The lower curve illustrates the situation in which the number of users is equal to two times the number of lines. As can be seen from the graphical results of Fig. 6, if the system has four users and two amplifier units, the probability of blocking is 5%. However, if the system has sixteen users and eight amplifier units, the probability of blocking is almost zero.

Fig. 7 graphically illustrates a similar result in respect of apparatus comprising eight amplifier units such as is illustrated in Figs. 1 to 4 illustrating the probability of a line being available (the "availability") in terms of the number of users of the 8-way system. As can be seen, a 99% availability is achievable with up to thirty-two users of the 8-way system.

Referring to Fig. 4, the combiner unit 8 of the 8-way system, or of any other such system according to the present invention, may comprise a diplexer unit 60 for receiving the output of the ultimate hybrid unit 47 of the combiner unit 8, for splitting the multi-channel broadband combined signal into two neighbouring narrower-band multi-channel signals and outputting the separate narrower-band signals (9a, 9b) to separate respective broadband transmission antennas (10a, 10b). Suitable narrower-band widths are a first bandwidth of 2-8MHz, and a second bandwidth of 8-30MHz. Other bandwidths may be used of course.

Figs 3 and 4 show complete, representative, HF systems comprising exciters, DLA matrix, amplifier units, CAW combiner and broadband antenna. An additional exciter unit, amplifier unit 52, ACU unit 53 and whip antenna 54 are shown in these figures and they collectively provide a function which is not essential to the function of the present invention, but would be preferable to meet the requirements of a typical complete HF system. The DLA function is beneficial to the transmit function, but a HF circuit preferably includes a reception function as well. The figures thus include the receive antennas 11 and multi-couplers (12,50, 51) to show completeness of the system.

Use of the transmitter system according to any of the embodiments discussed above may occur as follows. Consider a group of transmitter users of number exceeding eight, each user employing his/her own single exciter unit 2 at which they generate communications signals on an "as required" basis. That is to say an exciter unit is only deemed active when the user of it is active. This is a typical "press-to-talk" arrangement common to many transmitter systems. When a given user is active the allocating means searches amongst the eight amplifier units for an amplifier unit which is, at that time, idle. The idle amplifier unit (typically, the first amplifier found to be idle) is then allocated to the newly active user and the DLA matrix interconnects the former with the latter thereby enabling the active user's new communications signal to be amplified and forwarded to an antenna for transmission. It is to be noted that in typical "press-to-talk" systems users typically require the use of an amplifier only on an intermittent basis when, for example, responding to incoming communications signals. Of course, while a user is receiving (e.g. listening to) an incoming communications signal, he/she is generally not active and not requiring the use of an amplifier unit which he/she may only recently have been using. Thus, the newly idle amplifier unit may be allocated to another user who is currently active and requiring its use. This free-up of amplifier time and availability greatly enhances the efficiency of the signal transmitter system even when used by a number of users far in excess of the number of signal amplfier units within the system.

It is to be understood that variations and modifications, such as would be readily apparent to the skilled person, may be made to the exemplary embodiments of the invention described above without departing from the scope of the present invention.

## Claims

1. A signal amplifier apparatus for use with a wireless communications signal transmitter, the apparatus including a plurality of signal amplifier means each arranged to amplify communications signals received thereby for wireless transmission, allocating means operable to receive a plurality of concurrent communications signals and to allocate to each such signal any respective signal amplifier means not engaged in signal amplification, and tuning means operable to vary the frequency response of an allocated amplifier means according to the frequency of a given communications signal to which it is allocated so as to render the allocated amplifier operable to amplify the given communications signal.

2. Apparatus according to any preceding claim in which said tuning means is operable to vary the frequency response of an allocated amplifier means in response to the allocation thereof to a received communications signal.

3. Apparatus according to any preceding claim in which the allocating means has a plurality of signal input ports for receiving said communications signals, a plurality of signal output ports arranged to output received communications signals to said plurality of signal amplifier means for amplification, and switching means intermediate the plurality of signal input and output ports operable to selectively interconnect signal input ports to selected signal output ports thereby to route received communications signals to the signal amplifiers allocated thereto.

4. Apparatus according to claim 3 in which the allocating means possesses a greater number of said signal input ports than of said signal output ports.

5. Apparatus according to any of claims 3 and 4 in which the switching means is operable to interconnect a given signal input port of the allocating means to a single selected signal output port thereof.

6. Apparatus according to any of claims 3 to 5 in which each one of said plurality of amplifier means is arranged to receive and amplify communications signals from a respective separate one of said signal output ports of the allocating means.

7. Apparatus according to any preceding claim in which the allocating means includes monitoring means operable to determine which of the plurality of amplifier means are not engaged in signal amplification.

8. Apparatus according to any preceding claim in which one or more of the amplifier means includes signal filter means for variably filtering said communications signals received thereby, wherein the tuner means is operable to vary the frequency response of an allocated amplifier means by varying the signal filtering provided by the filter means thereof.

9. Apparatus according to any preceding claim including a plurality of communications signal generators wherein each one of said plurality of communication signal input ports of said allocating means is arranged to receive communications signals from a respective one of said plurality of communications signal generators.

10. Apparatus according to claim 9 in which each of said communications signal generators is arranged to generate an activation signal upon activation thereof, and said allocating means is responsive to a given activation signal to allocate to the given activated signal generator associated therewith an amplifier means not engaged in signal amplification.

11. Apparatus according to any preceding claim in which the tuning means is operable to tune the frequency response of an allocated amplifier means substantially to overlap the signal frequency bandwidth of the communications signal to which it is allocated.

12. Apparatus according to any preceding claim including signal combiner means for combining amplified communications signals output by said plurality of amplifier means and to output the combined signals for wireless transmission.

13. Apparatus according to any preceding claim including splitter means arranged to split a received communications signal into multiple concurrent signal portions and to input each of said multiple signal portions concurrently to a respective one of a corresponding multiple of said signal amplifier means, and re-combiner means arranged to receive said multiple concurrent signal portions output from said multiple signal amplifier means and to recombine them into a single signal.

14. Apparatus according to claim 13 in which the splitter means is arranged to split received communications signals into multiple concurrent and substantially coherent signal portions.

15. Apparatus according to any of claims 13 and 14 in which the re-combiner means is arranged to substantially coherently recombine said concurrent multiple signal portions received thereby.

16. Apparatus according to any of claims 13 to 15 in which said splitter means has a splitter input port arranged to receive communications signals from a signal output port of said allocating means, and multiple splitter output ports arranged to output said signal portions to output signal portions to a corresponding multiple signal input ports of said allocating means.

17. Apparatus according to any of claims 13 to 16 in which the splitter means is arranged to split received signal into substantially identical concurrent signal portions.

18. A wireless communications signal transmitter including the signal amplifier apparatus according to any preceding claim, the signal transmitter including a transmission antenna means for wirelessly transmitting communications signals output from said signal amplifier apparatus for wireless transmission.

19. A wireless communications signal transmitter according to claim 18 including the signal amplifier apparatus according to claim 12 wherein said antenna means is a single antenna operable to transmit said combined signals output by said signal combiner means.

20. A wireless signal transmitter according to claim 18 including the signal amplifier apparatus according to any of claims 1 to 11 wherein said antenna means includes a plurality of separate antenna elements each operable to separately transmit a different one of the plurality of amplified communications signals output by a respective one of said plurality of amplifier means.

21. A wireless signal transmitter according to claim 20 for transmitting Ultra-High Frequency (UHF) wireless communications signals in which each one of the plurality of separate antenna elements is substantially omni-directional in at least the azimuthal signal transmission plane thereof.

22. A method of signal amplification for use in wireless communications signal transmission, the method including providing a plurality of signal amplifier means each arranged to amplify communications signals received thereby for wireless transmission, providing a plurality of concurrent communications signals and allocating to each such signal any respective signal amplifier means not engaged in signal amplification, and varying the frequency response of an allocated amplifier means according to the frequency of a given communications signal to which it is allocated so as to render the allocated amplifier operable to amplify the given communications signal.

23. A method according to claim 22 in which said varying of the frequency response of an allocated amplifier means is done in response to the allocation thereof to a received communications signal.

24. A method according to any of preceding claims 22 and 23 in including providing allocating means for performing said allocating and having a plurality of signal input ports for receiving said communications signals, a plurality of signal output ports arranged to output received communications signals to said plurality of signal amplifier means for amplification, the method including selectively interconnecting signal input ports to selected signal output ports thereby to route received communications signals to the signal amplifiers allocated thereto.

25. A method according to claim 24 including providing the allocating means with a greater number of said signal input ports than of said signal output ports.

26. A method according to any of claims 24 and 25 including interconnecting a given signal input port of the allocating means to a single selected signal output port thereof.

27. A method according to any of claims 24 to 26 including receiving and amplifying at each one of said plurality of amplifier means communications signals from a respective separate one of said signal output ports of the allocating means.

28. A method according to any of preceding claims 22 to 27 including monitoring said plurality of amplifier means to determine which thereof are not engaged in signal amplification.

29. A method according to any of preceding claims 22 to 28 in which said varying of the frequency response of an allocated amplifier means includes variably filtering the signal received thereby.

30. A method according to any of preceding claims 22 to 29 including providing a plurality of communications signal generators and inputting to each one of said plurality of communication signal input ports of said allocating means a communications signal from a respective one of said plurality of communications signal generators.

31. A method according to claim 30 including generating an activation signal upon activation of a communications signal generator, and allocating to the given activated signal generator associated therewith an amplifier means not engaged in signal amplification.

32. A method according to any of preceding claims 22 to 31 including varying the frequency response of an allocated amplifier means substantially to overlap the signal frequency bandwidth of the communications signal to which it is allocated.

33. A method according to any of preceding claims 22 to 32 including combining amplified communications signals output by said plurality of amplifier means and outputting the combined signals for wireless transmission.

34. A method according to any of preceding claims 22 to 33 including splitting a received communications signal into multiple concurrent signal portions and inputting each of said multiple signal portions concurrently to a respective one of a corresponding multiple of said signal amplifier means, and recombining said multiple concurrent signal portions output from said multiple signal amplifier means into a single signal.

35. A method according to claim 34 in which said splitting of received communications signals is a splitting into multiple concurrent and substantially coherent signal portions.

36. A method according to any of claims 34 and 35 in which said recombining substantially coherently recombines said concurrent multiple signal portions.

37. Apparatus according to any of claims 13 to 16 in which said splitting splits said received signal into substantially identical concurrent signal portions.

38. A method of wireless communications including the method of signal amplification according to any of preceding claims 22 to 37 including wirelessly transmitting communications signals output from said signal amplifier apparatus for wireless transmission.

39. A method of wireless communications signal transmission according to claim 38 including the method of signal amplification according to claim 34 including transmitting said combined signals from a single antenna.

40. A method of wireless signal transmission according to claim 38 including the signal method of signal amplification according to any of claims 22 to 37 including separately transmitting each of the plurality of amplified communications signals output by a respective one of said plurality of amplifier means from a different one of a plurality of separate antenna elements.

41. A method according to claim 41 for transmitting Ultra-High Frequency (UHF) wireless communications signals including transmitting each of said plurality of amplified communications signals substantially omni-directionally in at least the azimuthal signal transmission plane thereof.

42. Apparatus substantially as described in any one embodiment hereinbefore with reference to the accompanying drawings.

43. A wireless signal transmitter substantially as described in any one embodiment hereinbefore with reference to the accompanying drawings.

44. A method of signal amplification substantially as described in any one embodiment hereinbefore with reference to the accompanying drawings.

45. A method of wireless signal transmission substantially as described in any one embodiment hereinbefore with reference to the accompanying drawings.

## Patentansprüche

1. Signalverstärkervorrichtung zur Verwendung mit einem drahtlosen Kommunikationssignalsender, wobei die Vorrichtung mehrere Signalverstärkermittel, die jeweils zum Verstärken von **dadurch** empfangenen Kommunikationssignalen zur drahtlosen Übertragung eingerichtet sind, ein Zuweisungsmittel, das betreibbar ist, um mehrere simultane Kommunikationssignale zu empfangen und jedem solchen Signal irgendein jeweiliges Signalverstärkermittel, das nicht mit der Signalverstärkung beschäftigt ist, zuzuweisen, und ein Abstimmmittel, das betreibbar ist, um die Frequenzcharakteristik eines zugewiesenen Verstärkermittels gemäß der Frequenz eines gegebenen Kommunikationssignals, dem es zugewiesen ist, zu verändern, um den zugewiesenen Verstärker betreibbar zu machen, um das gegebene Kommunikationssignal zu verstärken, enthält.

2. Vorrichtung nach einem vorangehenden Anspruch, wobei das Abstimmmittel betreibbar ist, um die Frequenzcharakteristik eines zugewiesenen Verstärkermittels in Reaktion auf dessen Zuweisung zu einem empfangenen Kommunikationssignal zu verändern.

3. Vorrichtung nach einem vorangehenden Anspruch, wobei das Zuweisungsmittel mehrere Signaleingangsanschlüsse zum Empfangen der Kommunikationssignale, mehrere Signalausgangsanschlüsse, die zum Ausgeben von empfangenen Kommunikationssignalen an die mehreren Signalverstärkermittel zur Verstärkung eingerichtet sind, und Schaltmittel zwischen den mehreren Signaleingangs- und Signalausgangsanschlüssen, die betreibbar sind, um selektiv Signaleingangsanschlüsse mit ausgewählten Signalausgangsanschlüssen zu verbinden, aufweist, um **dadurch** empfangene Kommunikationssignale zu den diesen zugewiesenen Signalverstärkern zu lenken.

4. Vorrichtung nach Anspruch 3, wobei das Zuweisungsmittel eine größere Anzahl der Signaleingangsanschlüsse als der Signalausgangsanschlüsse besitzt.

5. Vorrichtung nach einem der Ansprüche 3 und 4, wobei die Schaltmittel betreibbar sind, um einen gegebenen Signaleingangsanschluss des Zuweisungsmittels mit einem einzigen ausgewählten Signalausgangsanschluss davon zu verbinden.

6. Vorrichtung nach einem der Ansprüche 3 bis 5, wobei jedes der mehreren Verstärkermittel eingerichtet ist, um Kommunikationssignale von einem jeweiligen separaten der Signalausgangsanschlüsse des Zuweisungsmittels zu empfangen und zu verstärken.

7. Vorrichtung nach einem vorangehenden Anspruch, wobei das Zuweisungsmittel ein Überwachungsmittel enthält, das betreibbar ist, um festzustellen, welche der mehreren Verstärkermittel nicht mit der Signalverstärkung beschäftigt sind.

8. Vorrichtung nach einem vorangehenden Anspruch, wobei ein oder mehrere der Verstärkermittel Signalfiltermittel zum variablen Filtern der **dadurch** empfangenen Kommunikationssignale enthält/enthalten, wobei das Abstimmmittel betreibbar ist, um die Frequenzcharakteristik eines zugewiesenen Verstärkermittels durch Verändern der durch die Filtermittel davon geschaffenen Signalfilterung zu verändern.

9. Vorrichtung nach einem vorangehenden Anspruch, mit mehreren Kommunikationssignalgeneratoren, wobei jeder der mehreren Kommunikationssignal-Eingangsanschlüsse des Zuweisungsmittels eingerichtet ist, um Kommunikationssignale von einem jeweiligen der mehreren Kommunikationssignalgeneratoren zu empfangen.

10. Vorrichtung nach Anspruch 9, wobei jeder der Kommunikationssignalgeneratoren eingerichtet ist, um bei dessen Aktivierung ein Aktivierungssignal zu erzeugen, und das Zuweisungsmittel auf ein gegebenes Aktivierungssignal reagiert, um dem diesem zugeordneten gegebenen aktivierten Signalgenerator ein Verstärkermittel zuzuweisen, das nicht mit der Signalverstärkung beschäftigt ist.

11. Vorrichtung nach einem vorangehenden Anspruch, wobei das Abstimmmittel betreibbar ist, um die Frequenzcharakteristik eines zugewiesenen Verstärkermittels im Wesentlichen so abzustimmen, dass sie die Signalfrequenzbandbreite des Kommunikationssignals, dem es zugewiesen ist, überlappt.

12. Vorrichtung nach einem vorangehenden Anspruch, mit einem Signalkombinatormittel zum Kombinieren von verstärkten Kommunikationssignalen, die durch die mehreren Verstärkermittel ausgegeben werden, und um die kombinierten Signale für die drahtlose Übertragung auszugeben.

13. Vorrichtung nach einem vorangehenden Anspruch, mit einem Teilermittel, das eingerichtet ist, um ein empfangenes Kommunikationssignal in mehrere simultane Signalteile aufzuteilen und um jeden der mehreren Signalteile simultan in ein jeweiliges einer entsprechenden Mehrzahl der Signalverstärkermittel einzugeben, und einem Rekombinatormittel, das eingerichtet ist, um die mehreren simultanen Signalteile, die aus den mehreren Signalverstärkermitteln ausgegeben werden, zu empfangen und sie zu einem einzigen Signal zu rekombinieren.

14. Vorrichtung nach Anspruch 13, wobei das Teilermittel eingerichtet ist, um empfangene Kommunikationssignale in mehrere simultane und im Wesentlichen kohärente Signalteile aufzuteilen.

15. Vorrichtung nach einem der Ansprüche 13 und 14, wobei das Rekombinatormittel eingerichtet ist, um die **dadurch** empfangenen simultanen mehreren Signalteile im Wesentlichen kohärent zu rekombinieren.

16. Vorrichtung nach einem der Ansprüche 13 bis 15, wobei das Teilermittel einen Teilereingangsanschluss, der eingerichtet ist, um Kommunikationssignale von einem Signalausgangsanschluss des Zuweisungsmittels zu empfangen, und mehrere Teilerausgangsanschlüsse, die eingerichtet sind, um die Signalteile auszugeben, um Signalteile an entsprechende mehrere Signaleingangsanschlüsse des Zuweisungsmittels auszugeben, aufweist.

17. Vorrichtung nach einem der Ansprüche 13 bis 16, wobei das Teilermittel eingerichtet ist, um ein empfangenes Signal in im Wesentlichen identische simultane Signalteile aufzuteilen.

18. Drahtloser Kommunikationssignalsender mit der Signalverstärkervorrichtung nach einem vorangehenden Anspruch, wobei der Signalsender Sendeantennenmittel zur drahtlosen Übertragung von aus der Signalverstärkervorrichtung ausgegebenen Kommunikationssignalen für die drahtlose Übertragung enthält.

19. Drahtloser Kommunikationssignalsender nach Anspruch 18, mit der Signalverstärkervorrichtung nach Anspruch 12, wobei die Antennenmittel eine einzige Antenne sind, die betreibbar ist, um die durch das Signalkombinatormittel ausgegebenen kombinierten Signale zu übertragen.

20. Drahtloser Signalsender nach Anspruch 18, mit der Signalverstärkervorrichtung nach einem der Ansprüche 1 bis 11, wobei die Antennenmittel mehrere separate Antennenelemente enthalten, die jeweils betreibbar sind, um ein anderes der mehreren verstärkten Kommunikationssignale, die durch ein jeweiliges der mehreren Verstärkermittel ausgegeben werden, separat zu übertragen.

21. Drahtloser Signalsender nach Anspruch 20 zur Übertragung von drahtlosen Ultrahochfrequenz-Kommunikationssignalen (UHF-Kommunikationssignalen), wobei jedes der mehreren separaten Antennenelemente zumindest in der Signalübertragungs-Azimutebene davon im Wesentlichen rundstrahlend ist.

22. Verfahren zur Signalverstärkung zur Verwendung bei der drahtlosen Kommunikationssignalübertragung, wobei das Verfahren das Schaffen von mehreren Signalverstärkermitteln, die jeweils eingerichtet sind, um **dadurch** empfangene Kommunikationssignale zur drahtlosen Übertragung zu verstärken, das Schaffen von mehreren simultanen Kommunikationssignalen und das Zuweisen von irgendeinem jeweiligen Signalverstärkermittel, das nicht mit der Signalverstärkung beschäftigt ist, zu jedem solchen Signal und das Verändern der Frequenzcharakteristik eines zugewiesenen Verstärkermittels gemäß der Frequenz eines gegebenen Kommunikationssignals, dem es zugewiesen ist, um den zugewiesenen Verstärker betreibbar zu machen, um das gegebene Kommunikationssignal zu verstärken, enthält.

23. Verfahren nach Anspruch 22, wobei das Verändern der Frequenzcharakteristik eines zugewiesenen Verstärkermittels in Reaktion auf dessen Zuweisung zu einem empfangenen Kommunikationssignal durchgeführt wird.

24. Verfahren nach einem der vorangehenden Ansprüche 22 und 23, einschließlich des Schaffens eines Zuweisungsmittels zum Durchführen der Zuweisung und mit mehreren Signaleingangsanschlüssen zum Empfangen der Kommunikationssignale, mehreren Signalausgangsanschlüssen, die eingerichtet sind, um empfangene Kommunikationssignale an die mehreren Signalverstärkermittel zur Verstärkung auszugeben, wobei das Verfahren das selektive Verbinden von Signaleingangsanschlüssen mit ausgewählten Signalausgangsanschlüssen enthält, um **dadurch** empfangene Kommunikationssignale zu den diesen zugewiesenen Signalverstärkern zu lenken.

25. Verfahren nach Anspruch 24, einschließlich des Versehens des Zuweisungsmittels mit einer größeren Anzahl der Signaleingangsanschlüsse als der Signalausgangsanschlüsse.

26. Verfahren nach einem der Ansprüche 24 und 25, einschließlich des Verbindens eines gegebenen Signaleingangsanschlusses des Zuweisungsmittels mit einem einzelnen ausgewählten Signalausgangsanschluss davon.

27. Verfahren nach einem der Ansprüche 24 bis 26, einschließlich des Empfangens und Verstärkens von Kommunikationssignalen von einem jeweiligen separaten der Signalausgangsanschlüsse des Zuweisungsmittels an jedem der mehreren Verstärkermittel.

28. Verfahren nach einem der vorangehenden Ansprüche 22 bis 27, einschließlich des Überwachens der mehreren Verstärkermittel, um festzustellen, welche von diesen nicht mit der Signalverstärkung beschäftigt sind.

29. Verfahren nach einem der vorangehenden Ansprüche 22 bis 28, wobei das Verändern der Frequenzcharakteristik eines zugewiesenen Verstärkermittels das variable Filtern des **dadurch** empfangenen Signals enthält.

30. Verfahren nach einem der vorangehenden Ansprüche 22 bis 29, einschließlich des Schaffens von mehreren Kommunikationssignalgeneratoren und des Eingebens eines Kommunikationssignals von einem jeweiligen der mehreren Kommunikationssignalgeneratoren in jeden der mehreren Kommunikationssignal-Eingangsanschlüsse des Zuweisungsmittels.

31. Verfahren nach Anspruch 30, einschließlich des Erzeugens eines Aktivierungssignals bei der Aktivierung eines Kommunikationssignalgenerators und des Zuweisens eines Verstärkermittels, das nicht mit der Signalverstärkung beschäftigt ist, zu dem diesem zugeordneten gegebenen aktivierten Signalgenerator.

32. Verfahren nach einem der vorangehenden Ansprüche 22 bis 31, einschließlich des Veränderns der Frequenzcharakteristik eines zugewiesenen Verstärkermittels im Wesentlichen so, dass sie die Signalfrequenzbandbreite des Kommunikationssignals, dem es zugewiesen ist, überlappt.

33. Verfahren nach einem der vorangehenden Ansprüche 22 bis 32, einschließlich des Kombinierens von verstärkten Kommunikationssignalen, die durch die mehreren Verstärkermittel ausgegeben werden, und des Ausgebens der kombinierten Signale für die drahtlose Übertragung.

34. Verfahren nach einem der vorangehenden Ansprüche 22 bis 33, einschließlich des Aufteilens eines empfangenen Kommunikationssignals in mehrere simultane Signalteile und des simultanen Eingebens von jedem der mehreren Signalteile in ein jeweiliges einer entsprechenden Mehrzahl der Signalverstärkermittel und des Rekombinierens der mehreren simultanen Signalteile, die aus den mehreren Signalverstärkermitteln ausgegeben werden, zu einem einzigen Signal.

35. Verfahren nach Anspruch 34, wobei das Aufteilen von empfangenen Kommunikationssignalen ein Aufteilen in mehrere simultane und im Wesentlichen kohärente Signalteile ist.

36. Verfahren nach einem der Ansprüche 34 und 35, wobei das Rekombinieren die simultanen mehreren Signalteile im Wesentlichen kohärent rekombiniert.

37. Vorrichtung nach einem der Ansprüche 13 bis 16, wobei das Aufteilen das empfangene Signal in im Wesentlichen identische simultane Signalteile aufteilt.

38. Verfahren zur drahtlosen Kommunikation mit dem Verfahren zur Signalverstärkung nach einem der vorangehenden Ansprüche 22 bis 37, einschließlich des drahtlosen Übertragens von aus der Signalverstärkervorrichtung ausgegebenen Kommunikationssignalen für die drahtlose Übertragung.

39. Verfahren zur drahtlosen Kommunikationssignalübertragung nach Anspruch 38 mit dem Verfahren zur Signalverstärkung nach Anspruch 34, einschließlich des Übertragens der kombinierten Signale von einer einzigen Antenne.

40. Verfahren zur drahtlosen Signalübertragung nach Anspruch 38 mit dem Verfahren zur Signalverstärkung nach einem der Ansprüche 22 bis 37, einschließlich des separaten Übertragens von jedem der mehreren verstärkten Kommunikationssignale, die durch ein jeweiliges der mehreren Verstärkermittel ausgegeben werden, von einem anderen von mehreren separaten Antennenelementen.

41. Verfahren nach Anspruch 41 zur Übertragung von drahtlosen Ultrahochfrequenz-Kommunikationssignalen (UHF-Kommunikationssignalen), einschließlich des Übertragens von jedem der mehreren verstärkten Kommunikationssignale im Wesentlichen rundstrahlend in zumindest der Signalübertragungs-Azimutebene davon.

42. Vorrichtung, im Wesentlichen wie in irgendeiner Ausführungsform vorher mit Bezug auf die begleitenden Zeichnungen beschrieben.

43. Drahtloser Signalsender, im Wesentlichen wie in irgendeiner Ausführungsform vorher mit Bezug auf die begleitenden Zeichnungen beschrieben.

44. Verfahren zur Signalverstärkung, im Wesentlichen wie in irgendeiner Ausführungsform vorher mit Bezug auf die begleitenden Zeichnungen beschrieben.

45. Verfahren zur drahtlosen Signalübertragung, im Wesentlichen wie in irgendeiner Ausführungsform vorher mit Bezug auf die begleitenden Zeichnungen beschrieben.

## Revendications

1. Appareil amplificateur de signaux destiné à être utilisé avec un émetteur de signaux de communications sans fil, cet appareil comprenant une pluralité de moyens amplificateurs de signaux dont chacun est agencé de façon à amplifier les signaux de communications ainsi reçus pour une émission sans fil, un moyen d'attribution utilisable pour recevoir une pluralité de signaux de communications simultanés et pour attribuer à chacun desdits signaux n'importe quel moyen amplificateur de signaux respectif non engagé dans l'amplification de signaux, et un moyen de réglage utilisable pour faire varier la réponse en fréquence d'un moyen amplificateur attribué selon la fréquence d'un signal de communications donné auquel il est attribué de façon à rendre l'amplificateur attribué utilisable pour amplifier le signal de communications donné.

2. Appareil selon l'une quelconque des revendications précédentes, dans lequel ledit moyen de réglage est utilisable pour faire varier la réponse en fréquence d'un moyen amplificateur attribué en réponse à l'attribution de celui-ci à un signal de communications reçu.

3. Appareil selon l'une quelconque des revendications précédentes, dans lequel le moyen d'attribution a une pluralité de points d'accès d'entrée de signaux pour recevoir lesdits signaux de communications, une pluralité de points d'accès de sortie de signaux agencés de façon à délivrer les signaux de communications reçus vers ladite pluralité de moyens amplificateurs de signaux pour qu'ils soient amplifiés, et un moyen de commutation intermédiaire à la pluralité de points d'accès d'entrée et de sortie de signaux utilisable pour interconnecter sélectivement les points d'accès d'entrée de signaux à des points d'accès de sortie de signaux sélectionnés afin d'acheminer ainsi les signaux de communications reçus jusqu'aux amplificateurs de signaux attribués à ceux-ci.

4. Appareil selon la revendication 3, dans lequel le moyen d'attribution possède un plus grand nombre desdits points d'accès d'entrée de signaux que desdits points d'accès de sortie de signaux.

5. Appareil selon l'une quelconque des revendications 3 ou 4, dans lequel le moyen de commutation est utilisable pour interconnecter un point d'accès d'entrée de signaux donné du moyen d'attribution à un seul point d'accès de sortie de signaux sélectionné de celui-ci.

6. Appareil selon l'une quelconque des revendications 3 à 5, dans lequel chacun desdits moyens amplificateurs est agencé de manière à recevoir et à amplifier les signaux de communications venant d'un point d'accès séparé respectif desdits points d'accès de sortie de signaux du moyen d'attribution.

7. Appareil selon l'une quelconque des revendications précédentes, dans lequel le moyen d'attribution comprend un moyen de surveillance utilisable pour déterminer lesquels de la pluralité de moyens amplificateurs ne sont pas engagés dans l'amplification des signaux.

8. Appareil selon l'une quelconque des revendications précédentes, dans lequel un ou plusieurs des moyens amplificateurs comprennent un moyen de filtrage des signaux pour filtrer de manière variable lesdits signaux de communication reçus ainsi, le moyen d'accord étant utilisable pour faire varier la réponse en fréquence d'un moyen amplificateur attribué en faisant varier le filtrage des signaux fourni par le moyen de filtrage de celui-ci.

9. Appareil selon l'une quelconque des revendications précédentes, comprenant une pluralité de générateurs de signaux de communications, chacun desdits points d'accès d'entrée de signaux de communication dudit moyen d'attribution étant agencé de façon à recevoir les signaux de communication provenant d'un générateur respectif de ladite pluralité de générateurs de signaux de communications.

10. Appareil selon la revendication 9, dans lequel chacun desdits générateurs de signaux de communications est agencé de façon à générer un signal d'activation lors de l'activation de celui-ci, et ledit moyen d'attribution est réceptif à un signal d'activation donné pour attribuer au générateur de signaux activé associé à celui-ci un moyen amplificateur non engagé dans l'amplification de signaux.

11. Appareil selon l'une quelconque des revendications précédentes, dans lequel le moyen de réglage est utilisable pour accorder la réponse en fréquence d'un moyen amplificateur attribué essentiellement pour dépasser la largeur de bande de fréquences du signal de communications auquel il est attribué.

12. Appareil selon l'une quelconque des revendications précédentes, comprenant un moyen combinateur de signaux pour combiner des signaux de communications amplifiés délivrés par ladite pluralité de moyens amplificateurs et pour délivrer ces signaux combinés pour une émission sans fil.

13. Appareil selon l'une quelconque des revendications précédentes comprenant un moyen diviseur agencé de façon à diviser un signal de communications reçu en de multiples parties de signal simultanées et à faire entrer simultanément chacune desdites parties de signal multiples dans un moyen respectif desdits moyens amplificateurs de signaux multiples correspondants, et un moyen recombinateur agencé de façon à recevoir lesdites parties de signal simultanées multiples délivrées par lesdits moyens amplificateurs de signaux multiples et à les recombiner en un signal unique.

14. Appareil selon la revendication 13, dans lequel le moyen diviseur est agencé de façon à diviser les signaux de communications reçus en de multiples parties de signal simultanées et essentiellement cohérentes.

15. Appareil selon l'une quelconque des revendications 13 et 14, dans lequel le moyen recombinateur est agencé de façon à recombiner de manière essentiellement cohérente lesdites multiples parties de signal simultanées ainsi reçues.

16. Appareil selon l'une quelconque des revendications 13 à 15, dans lequel ledit moyen diviseur a un point d'accès d'entrée de diviseur agencé de façon à recevoir des signaux de communications d'un point d'accès de sortie de signaux dudit moyen d'attribution, et des points d'accès de sortie de diviseurs multiples agencés de façon à délivrer lesdites parties de signal afin de délivrer les parties de signal vers des points d'accès d'entrée de signaux multiples correspondants audit moyen d'attribution.

17. Appareil selon l'une quelconque des revendications 13 à 16, dans lequel le moyen diviseur est agencé de façon à diviser le signal reçu en des parties de signal simultanées essentiellement identiques.

18. Émetteur de signaux de communications sans fil comprenant l'appareil amplificateur de signaux selon l'une quelconque des revendications précédentes, cet émetteur de signaux comprenant un moyen antennaire d'émission pour émettre sans fil des signaux de communications délivrés par ledit appareil amplificateur de signaux pour une émission sans fil.

19. Émetteur de signaux de communications sans fil selon la revendication 18, comprenant l'appareil amplificateur de signaux selon la revendication 12, dans lequel ledit moyen antennaire est une seule antenne utilisable pour émettre lesdits signaux combinés délivrés par ledit moyen combinateur de signaux.

20. Émetteur de signaux sans fil selon la revendication 18, comprenant l'appareil amplificateur de signaux selon l'une quelconque des revendications 1 à 11, dans lequel ledit moyen antennaire comprend une pluralité d'éléments antennaires séparés, chacun étant utilisable pour émettre séparément un signal différent de la pluralité de signaux de communications amplifiés délivrés par un moyen respectif de ladite pluralité de moyens amplificateurs.

21. Émetteur de signaux sans fil selon la revendication 20 pour émettre des signaux de communications sans fil à ultra-haute fréquence (UHF), dans lequel chacun de la pluralité d'éléments antennaires séparés est essentiellement omnidirectionnel dans au moins le plan azimutal d'émission de ces signaux.

22. Procédé d'amplification de signaux destiné à être utilisé dans l'émission de signaux de communications sans fil, ce procédé comprenant la prévision d'une pluralité de moyens amplificateurs de signaux dont chacun est agencé de façon à amplifier les signaux de communications ainsi reçus pour une émission sans fil, la prévision d'une pluralité de signaux de communications simultanés et l'attribution à chacun de ces signaux de n'importe quel moyen amplificateur de signaux respectif non engagé dans l'amplification de signaux, et la variation de la réponse en fréquence d'un moyen amplificateur attribué selon la fréquence d'un signal de communications donné auquel il est attribué de façon à rendre l'amplificateur attribué utilisable pour amplifier le signal de communications donné.

23. Procédé selon la revendication 22, dans lequel ladite variation de la réponse en fréquence d'un moyen amplificateur attribué est faite en réponse à l'attribution de celui-ci à un signal de communications reçu.

24. Procédé selon l'une quelconque des revendications précédentes 22 et 23, comprenant la prévision d'un moyen d'attribution pour effectuer ladite attribution et ayant une pluralité de points d'accès d'entrée de signaux pour recevoir lesdits signaux de communications, une pluralité de points d'accès de sortie de signaux agencés de façon à délivrer les signaux de communications reçus vers ladite pluralité de moyens amplificateurs de signaux pour qu'ils soient amplifiés, ce procédé comprenant l'interconnexion sélective des points d'accès d'entrée de signaux à des points d'accès de sortie de signaux sélectionnés afin d'acheminer ainsi les signaux de communications reçus jusqu'aux amplificateurs de signaux attribués à ceux-ci.

25. Procédé selon la revendication 24, comprenant la prévision du moyen d'attribution avec un plus grand nombre desdits points d'accès d'entrée de signaux que desdits points d'accès de sortie de signaux.

26. Procédé selon l'une quelconque des revendications 24 ou 25, comprenant l'interconnexion d'un point d'accès d'entrée de signaux donné du moyen d'attribution à un seul point d'accès de sortie de signaux sélectionné de celui-ci.

27. Procédé selon l'une quelconque des revendications 24 à 26, comprenant la réception et l'amplification pour chacun de ladite pluralité de moyens amplificateurs de signaux de communications venant d'un point d'accès séparé respectif desdits points d'accès de sortie de signaux du moyen d'attribution.

28. Procédé selon l'une quelconque des revendications précédentes 22 à 27, comprenant la surveillance de ladite pluralité de moyens amplificateurs afin de déterminer lesquels parmi ceux-ci ne sont pas engagés dans l'amplification de signaux.

29. Procédé selon l'une quelconque des revendications précédentes 22 à 28, dans lequel ladite variation de la réponse en fréquence d'un moyen amplificateur attribué comprend le filtrage variable du signal ainsi reçu.

30. Procédé selon l'une quelconque des revendications précédentes 22 à 29 comprenant la prévision d'une pluralité de générateurs de signaux de communications, et la réception dans chacun de ladite pluralité de points d'accès d'entrée de signaux de communications dudit moyen d'attribution d'un signal de communications provenant d'un générateur respectif de ladite pluralité de générateurs de signaux de communications.

31. Procédé selon la revendication 30, comprenant la génération d'un signal d'activation lors de l'activation d'un générateur de signaux de communications, et l'attribution au générateur de signaux activé donné associé à celui-ci d'un moyen amplificateur non engagé dans l'amplification de signaux.

32. Procédé selon l'une quelconque des revendications précédentes 22 à 31, comprenant la variation de la réponse en fréquence d'un moyen amplificateur attribué essentiellement pour dépasser la largeur de bande de fréquences du signal de communications auquel il est attribué.

33. Procédé selon l'une quelconque des revendications précédentes 22 à 32, comprenant la combinaison de signaux de communications amplifiés délivrés par ladite pluralité de moyens amplificateurs et la délivrance des signaux combinés pour une émission sans fil.

34. Procédé selon l'une quelconque des revendications précédentes 22 à 33, comprenant la division d'un signal de communications reçu en des parties de signal simultanées multiples et la réception simultanée de chacune desdites parties de signal multiples dans un moyen respectif desdits moyens amplificateurs de signaux multiples correspondants, et la recombinaison desdites parties de signal simultanées multiples délivrées par lesdits moyens amplificateurs de signaux multiples en un signal unique.

35. Procédé selon la revendication 34, dans lequel ladite division de signaux de communications reçus est une division en parties de signal simultanées multiples et essentiellement cohérentes.

36. Procédé selon l'une quelconque des revendications 34 et 35, dans lequel ladite recombinaison recombine essentiellement simultanément lesdites parties de signal multiples simultanées.

37. Appareil selon l'une quelconque des revendications 13 à 16, dans lequel ladite division divise ledit signal reçu en des parties de signal simultanées essentiellement identiques.

38. Procédé de communications sans fil comprenant le procédé d'amplification de signaux selon l'une quelconque des revendications précédentes 22 à 37, comprenant l'émission sans fil de signaux de communications délivrés par ledit appareil amplificateur de signaux pour une émission sans fil.

39. Procédé d'émission de signaux communications sans fil selon la revendication 38, comprenant le procédé d'amplification de signaux selon la revendication 34, comprenant l'émission desdits signaux combinés à partir d'une seule antenne.

40. Procédé d'émission de signaux sans fil selon la revendication 38, comprenant le procédé d'amplification de signaux selon l'une quelconque des revendications 22 à 37, comprenant l'émission séparée de chacun de la pluralité de signaux de communication amplifiés délivrés par un moyen respectif de ladite pluralité de moyens amplificateurs à partir d'un élément différent d'une pluralité d'éléments antennes séparés

41. Procédé selon la revendication 41 pour émettre des signaux de communications sans fil à ultra-haute fréquence (UHF), comprenant l'émission de chacun de ladite pluralité de signaux de communications amplifiés de manière essentiellement omnidirectionnelle dans au moins le plan azimutal d'émission de signaux de ceux-ci

42. Appareil essentiellement tel que décrit dans l'un quelconque des modes de réalisation ci-dessus en référence aux dessins d'accompagnement.

43. Émetteur de signaux sans fil essentiellement tel que décrit dans l'un quelconque des modes de réalisation ci-dessus en référence aux dessins d'accompagnement.

44. Procédé d'amplification de signaux essentiellement tel que décrit dans l'un quelconque des modes de réalisation ci-dessus en référence aux dessins d'accompagnement.

45. Procédé d'émission de signaux sans fil essentiellement tel que décrit dans l'un quelconque des modes de réalisation ci-dessus en référence aux dessins d'accompagnement.
